Europäisches Patentamt

European Patent Office

Office européen des brevets

(11) Veröffentlichungsnummer: **0 208 082**
**A2**

(12) **EUROPÄISCHE PATENTANMELDUNG**

(21) Anmeldenummer: 86106251.1

(22) Anmeldetag: 07.05.86

(51) Int. Cl.⁴: **H03G 3/34**

(30) Priorität: 12.07.85 DE 3524847

(43) Veröffentlichungstag der Anmeldung:
14.01.87 Patentblatt 87/03

(84) Benannte Vertragsstaaten:
AT DE FR IT

(71) Anmelder: **GRUNDIG E.M.V.**
**Elektro-Mechanische Versuchsanstalt Max**
**Grundig holländ. Stiftung & Co. KG.**
**Kurgartenstrasse 37**
**D-8510 Fürth(DE)**

(72) Erfinder: **Glaab, Arnold, Dr.**
**Wilhelm-Raabe-Strasse 27**
**D-8510 Fürth(DE)**

(54) **Rundfunkempfangsgerät mit einer Anordnung zur Störimpulsaustastung.**

(57) Bei einem Rundfunkempfangsgerät mit einem Störungsdetektor, der impulsartige Störungen im Empfangssignal HF-seitig auswertet und abhängig hiervon eine Störimpulsunterdrückungsschaltung steuert, ist die Störimpulsunterdrückungsschaltung als digitale Signalverarbeitungsschaltung ausgebildet. Diese besteht aus einem Analog-Digital-Wandler, der das demodulierte, analoge, Rundfunkempfangssignal in ein Digitalsignal umwandelt, einer Schaltung zur Impulsverbreiterung, die unabhängig von der Abtastfrequenz das beim Auftreten einer Störung vom Störungsdetektor abgegebene Austastsignal zeitlich an die auf der NF-Seite durch Bandbegrenzung bedingte vergrößerte Störimpulsbreite anpaßt sowie einem von der Schaltung zur Impulsverbreiterung gesteuerten digitalen Filter, das die während der Dauer der impulsartigen Störung gewonnenen Abtastwerte des Digitalsignals unterdrückt. Ferner verfügt die digitale Signalverarbeitungsschaltung über eine digitale Interpolationsschaltung, die die unterdrückten Abtastwerte des Digitalsignals durch korrigierte Werte ersetzt sowie über eine Prozessor-und Speichereinheit, die entsprechend dem gewünschten Funktionsverlauf der Interpolation die Ermittlung der korrigierten Abtastwerte durchführt.

# RUNDFUNKEMPFANGSGERÄT MIT EINER ANORDNUNG ZUR STÖRIMPULSAUSTASTUNG

Die Erfindung betrifft ein Rundfunkempfangsgerät mit einem Störungsdetektor, der impulsartige Störungen im Empfangssignal HF-seitig auswertet und abhängig hiervon eine Störimpulsunterdrückungsschaltung steuert.

Es sind verschiedene Verfahren und Anordnungen zur Austastung von Störimpulsen, insbesondere Zündfunkenstörungen bei in Kraftfahrzeugen betriebenen Rundfunkempfängern, bekannt. Ein Verfahren besteht darin, den während der Dauer einer Störung gestörten Teil des Nutzsignals zu unterdrücken und durch einen zeitlich konstanten Signalpegel, der dem unmittelbar vor dem Auftreten der Störung anliegenden Pegelwert entspricht, zu ersetzen. Diese Art der Störimpulsunterdrückung hat allerdings neue Störerscheinungen zur Folge, da das Nutzsignal unmittelbar nach dem Auftreten des Störimpulses in der Regel einen anderen Pegelwert aufweist als vorher. Hierdurch ergibt sich am Ende der Störsignalaustastung eine sehr steil ansteigende oder abfallende Flanke und damit eine Unstetigkeit im Nutzsignalverlauf.

Aus der DE-OS 29 29 030 ist ein Verfahren zur Störimpulsunterdrückung bekannt, bei dem während des Auftretens der Störung der ungestörte Nutzsignalverlauf durch ein Korrektursignal angenähert wird. Das Korrektursignal wird hierbei aus einem Differenzsignal erzeugt, welches aus dem die Störimpulse enthaltenden Eingangssignal und einem durch Verzögerung des Eingangssignals um eine vorbestimmte Zeitdauer erhaltenen Signal gewonnen wird. Eine befriedigende Korrektur des gestörten Empfangssignals ist jedoch auch mit diesem Verfahren nicht immer möglich. Zudem ist seine technische Verwirklichung sehr aufwendig und teuer.

Ein weiteres Verfahren zur Unterdrückung von impulsartigen Störungen (Impulsrauschen) ist in der DE-OS 30 16 118 beschrieben. Dort wird das Rausch-bzw. Störsignal nicht NF-seitig, sondern in der ZF-Signal stufe beseitigt. Hierdurch ergibt sich eine durch ein Konstantsignal zu ersetzende Rauschimpulsbreite, die sehr viel kleiner ist als die, die bei einer auf der NF-Seite arbeitenden Austastschaltung in Erscheinung tritt. Es wurde jedoch festgestellt, daß auch auf diese Weise keine befriedigende Störimpulsunterdrückung erreichbar ist.

Der Erfindung liegt die Aufgabe zugrunde, ein Rundfunkempfangsgerät der im Oberbegriff des Anspruchs 1 angegebenen Art so auszubilden, daß im Empfangssignal auftretende Störimpulse sicher erkannt, ausgetastet und in einfacher Weise jeweils durch ein dem ungestörten Nutzsignalverlauf optimal angepaßtes Korrektursignal ersetzt werden.

Diese Aufgabe wird gemäß der Erfindung durch die im kennzeichnenden Teil des Patentanspruchs 1 angegebenen Merkmale gelöst. Vorteilhafte Weiterbildungen der Erfindung sind in den Unteransprüchen gekennzeichnet.

Bei dem Rundfunkempfangsgerät gemäß der Erfindung ist die Störunterdrückungsschaltung als digitale Signalverarbeitungsschaltung ausgebildet. Diese verfügt über eine mit einer Prozessor-und Speichereinheit gekoppelte digitale Interpolationsschaltung.

Erst hierdurch ergibt sich in vorteilhafter Weise die Möglichkeit, das Empfangssignal nach Eliminierung der Störung optimal zu korrigieren. Über die Prozessor-und Speichereinheit kann nämlich bei einem digital aufbereiteten Empfangssignal ohne großen Aufwand eine Interpolation nach Maßgabe einer Potenzfunktion vom Grad Null, Eins oder höher durchgeführt werden. Die Erkennung der Störung selbst erfolgt in an sich bekannter Weise HF-seitig mit Hilfe eines geeigneten Störungsdetektors. Das von diesem an die digitale Signalverarbeitungsschaltung abgegebene Signal wird in vorteilhafter Weise nicht mit der Abtastrate der digitalen Signalverarbeitungsschaltung abgetastet, sondern einer Schaltung zur Impulsverbreiterung zugeführt, die ihrerseits ein digitales Filter steuert. Hierdurch ist ein sicheres Erkennen der Störung gewährleistet, was bei einer (NF-seitigen) Abtastung des betreffenden Signals nicht der Fall wäre, da die Dauer der detektierten Störung im Vergleich zu den üblichen (NF-seitigen) Abtastraten sehr kurz ist. Beispielsweise wird die Dauer einer Zündfunkenstörung am Detektor nahezu ausschließlich durch die Bandbreite des Empfängers bestimmt, da die Anstiegszeit eines Zündfunkens im Vergleich zur Einschwingzeit des Verstärkers im Empfänger vernachlässigbar klein ist. Bei einer typischen ZF-Bandbreite von zum Beispiel 200 kHz hat die Störung am Ausgang des Detektors lediglich eine Dauer von etwa 5 Mikrosekunden und könnte damit mit einer Abtastfrequenz von 32 kHz nicht sicher erkannt werden.

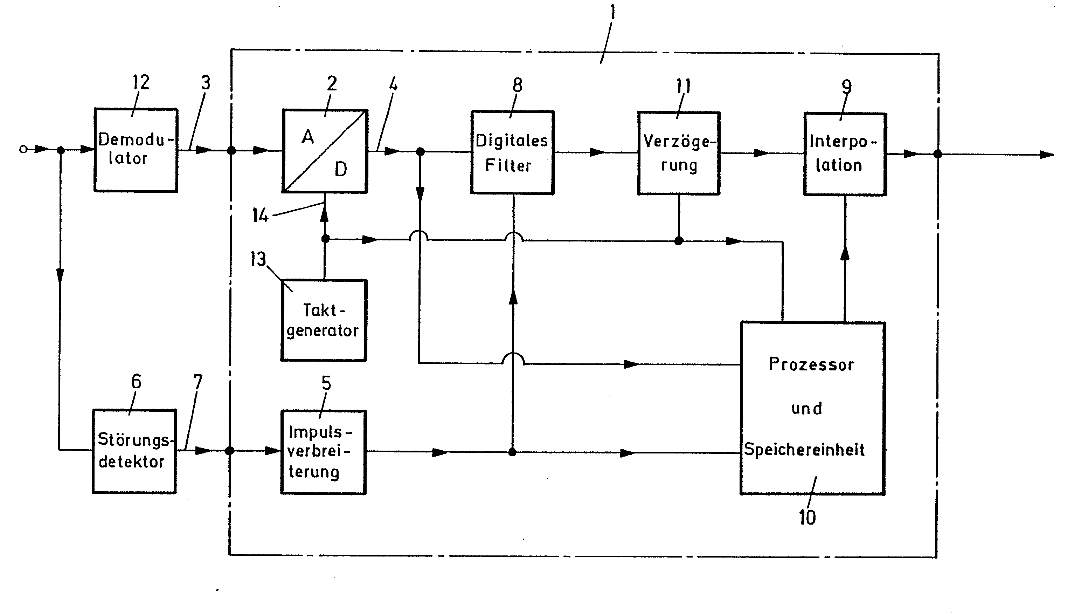

Die Erfindung ist im folgenden anhand eines Blockschaltbildes näher erläutert. Die Figur gibt im wesentlichen den prinzipiellen Aufbau eines Ausführungsbeispiels für eine digitale Störimpulsunterdrückungsschaltung wieder.

Wie der Darstellung zu entnehmen ist, werden einer digitalen Signalverarbeitungsschaltung 1 zwei Eingangssignale 3 und 7 zugeführt. Hierbei handelt es sich um das von einem Demodulator 12 kommende analoge Rundfunkempfangssignal 3 sowie um das von einem Störungsdetektor 6 kommende Eingangssignal 7. Das demodulierte, analoge Rundfunkempfangssignal 3 wird mit Hilfe eines Analog-Digital-Wandlers 2 in ein Digitalsignal 4 umgewandelt. Ein Taktgenerator 13 liefert das für den Abtastvorgang notwendige Steuersignal 14. Das zweite, der digitalen Signalverarbeitungsschaltung 1 zugeführte und vom Störungsdetektor 6 kommende Eingangssignal wird über eine Schaltung 5 zur Impulsverbreiterung an die auf der NF-Seite durch Bandbegrenzung bedingte vergrößerte Störimpulsbreite angepaßt. Hierbei wird ein Austastsignal erzeugt, welches ein dem Analog-Digital-Wandler nachgeschaltetes digitales Filter derart steuert, daß die während der Dauer der impulsartigen Störung gewonnenen Abtastwerte des Digitalsignals 4 unterdrückt werden. Die einzelnen Abtastwerte des Digitalsignals 4 sowie das von der Schaltung 5 abgegebene Austastsignal werden ferner zur weiteren Verarbeitung einer Prozessor-und Speichereinheit 10 zugeführt. Mit Hilfe dieser Einheit werden aus den letzten Abtastwerten vor Auftreten der Störung und den ersten Abtastwerten nach Verschwinden der Störung Zwischenwerte ermittelt, die in einer digitalen Interpolationsschaltung 9 die als gestört erkannten und ausgefilterten Abtastwerte ersetzen. Je nach verwendetem Programm ermöglicht die Prozessor-und Speichereinheit 10 eine digitale Interpolation vom Funktionsgrad Null, Eins oder höher.

Die in der Figur dargestellte digitale Signalverarbeitungsschaltung 1 weist zwischen dem digitalen Filter 8 und der digitalen Interpolationsschaltung 9 in vorteilhafter Weise noch eine Verzögerungseinrichtung 11 auf. Diese verzögert das zu verarbeitende Signal wenigstens um die Dauer der impulsartigen Störung zuzüglich der doppelten Abtastzeit der Analog-Digital-Wandlung, so daß während der Verzögerung die Interpolationswerte ermittelt werden können.

Soll das Rundfunkempfangsgerät gemäß der Erfindung sowohl für den FM-, als auch den AM-Bereich ausgelegt sein, dann ist es von Vorteil, die Schaltung 5 zur Impulsverbreiterung aufgrund der verschiedenen Bandbreiten und der damit verbundenen unterschiedlichen Störimpulsverbreiterungen umschaltbar zu gestalten. In einer bevorzugten Ausführungsform ist als Schaltung zur Impulsverbreiterung ein mit festen Zeiten zurücksetzbares Flipflop vorgesehen.

## Ansprüche

1. Rundfunkempfangsgerät mit einem Störungsdetektor, der impulsartige Störungen im Empfangssignal HF-seitig auswertet und abhängig hiervon eine Störimpulsunterdrückungsschaltung steuert, **dadurch gekennzeichnet,** daß die Störimpulsunterdrückungsschaltung als digitale Signalverarbeitungsschaltung (1) ausgebildet ist, welche aus folgenden Bausteinen besteht:

a) einem Analog-Digital-Wandler (2), der das demodulierte, analoge Rundfunkempfangssignal (3) in ein Digitalsignal (4) umwandelt,

b) einer Schaltung (5) zur Impulsverbreiterung, die unabhängig von der Abtastfrequenz das beim Auftreten einer Störung vom Störungsdetektor (6) abgegebene Austastsignal (7) zeitlich an die auf der NF-Seite durch Bandbegrenzung bedingte vergrößerte Störimpulsbreite anpaßt,

c) einem von der Schaltung (5) zur Impulsverbreiterung gesteuerten digitalen Filter (8), das die während der Dauer der impulsartigen Störung gewonnenen Abtastwerte des Digitalsignals (4) unterdrückt,

d) einer digitalen Interpolationsschaltung (9), die die unterdrückten Abtastwerte des Digitalsignals durch korrigierte Werte ersetzt,

e) einer Prozessor-und Speichereinheit (10), die entsprechend dem gewünschten Funktionsverlauf der Interpolation die Ermittlung der korrigierten Abtastwerte durchführt.

2. Rundfunkempfangsgerät nach Anspruch 1, **dadurch gekennzeichnet,** daß die digitale Signalverarbeitungsschaltung (1) eine Verzögerungseinrichtung (11) enthält, die das zu verarbeitende Signal wenigstens um die Dauer der impulsartigen Störung zuzüglich der doppelten Abtastzeit der Analog-Digital-Wandlung verzögert.

3. Rundfunkempfangsgerät nach Anspruch 1 oder 2, **dadurch gekennzeichnet,** daß die Prozessor-und Speichereinheit (10) der digitalen Signalverarbeitungsschaltung (1) eine digitale Interpolation nach Maßgabe einer Potenzfunktion vom Grad Null, Eins oder höher ermöglicht.

4. Rundfunkempfangsgerät nach einem oder mehreren der Ansprüche 1 bis 3, **dadurch gekennzeichnet,** daß die Schaltung (5) zur Impulsverbreiterung der digitalen Signalverarbeitungsschaltung (1) auf die im FM-und AM-Bereich infolge unterschiedlicher Bandbreiten verschiedenen Störimpulsverbreiterungen umschaltbar ist.

5. Rundfunkempfangsgerät nach einem oder mehreren der Ansprüche 1 bis 4, **dadurch gekennzeichnet,** daß als Schaltung (5) zur Impulsverbreiterung ein mit festen Zeiten zurücksetzbares Flipflop vorgesehen ist.

Reg. 2009

Demodulator 12 3

A/D 2 4

Digitales Filter 8

Verzöge- rung 11

Interpo- lation 9

Prozessor und Speichereinheit 10

Taktgenerator 13

14

Störungs- detektor 6 7

Impuls- verbrei- terung 5

1